# EUROPEAN PATENT APPLICATION

(11) **EP 4 679 957 A1**
(43) Date of publication of application: **14.01.2026**
(21) Application number: 25187721.3
(22) Date of filing: 07.07.2025
(51) Int. Cl.: H05K 7/20

(54) **BAFFLES FOR COOLANT DISTRIBUTION UNITS**

(30) Priority: 09.07.2024 US 202463669190 P
(71) Applicant: Hoffman Enclosures Inc., Anoka, MN 55303 (US)
(72) Inventor: KUNDEM, Jeshwanth Durga Sagar, Minneapolis, 55408 (US)
(74) Representative: Barker Brettell LLP

(57) **Abstract**

A coolant distribution unit (CDU) (302) includes a housing (305) having a first end (104) and a second end (110), a first fan row (308) arranged on the second end of the housing, the first fan row including a first fan to move air through the housing from the first end to the second end, and a baffle system (320) secured to the second end of the housing. The baffle system includes a first baffle (304) to guide air flow from the first fan row, the first baffle having a plurality of sequentially arranged vanes, each vane defining a plane forming an angle relative to an axis parallel to an airflow direction through the CDU, and each vane in the sequence being oriented at a greater angle relative to the axis than the preceding vane in the sequence.

## Description

### CROSS-REFERENCE TO RELATED APPLICATIONS

This application claims the benefit of U.S. Provisional Application No. 63/669,190, filed July 9, 2024, which is hereby incorporated by reference in its entirety.

### BACKGROUND

Within a data center, electrical equipment can be arranged in rows, with aisles between the rows. Electrical equipment in a data center can require cooling to maintain a temperature of the equipment within a desired operating range. Cooling for electrical equipment can include an air flow to produce a heat transfer of waste heat away from electrical equipment. In some cases, an aisle on a first side of a row of electrical equipment can include cooled (e.g., air conditioned) air, and an aisle on a second side of the row, opposite the first side can be a "hot aisle." Cooling systems of the data center can produce an air flow through the row in a direction from the cold aisle to the hot aisle to cool electrical equipment.

### SUMMARY

According to one aspect of the present disclosure, a coolant distribution unit (CDU) can include a housing having a first end and a second end. A first fan row can be arranged on the second end of the housing, the first fan row including a first fan to move air through the housing from the first end to the second end. A baffle system can be secured to the second end of the housing, the baffle system including a first baffle to guide air flow from the first fan row. The first baffle can have a plurality of sequentially arranged vanes, each vane defining a plane forming an angle relative to an axis parallel to an airflow direction through the CDU, and each vane in the sequence being oriented at a greater angle relative to the axis than the preceding vane in the sequence.

In some examples, the first baffle can include three vanes.

In some examples, a first vane can be angled at about 10 degrees relative to the axis, a second vane can be angled at about 20 degrees relative to the axis, and a third vane can be angled at about 27 degrees relative to the axis.

In some examples, the first vane can have a length of about 5 inches, the second vane can have a length of about 2 inches, and the third vane can have a length of about 2.5 inches.

In some examples, the coolant distribution unit can further include a second fan row arranged on the second end of the housing, the second fan row including a second fan to move air through the housing from the first end to the second end.

In some examples, the baffle system can further include a second baffle to guide air flow from the second fan row, the second baffle having a plurality of sequentially arranged vanes, each vane defining a plane forming an angle relative to an axis parallel to an airflow direction through the CDU, and each vane in the sequence being oriented at a greater angle relative to the axis than the preceding vane in the sequence.

In some examples, the second baffle can include three vanes, and a first vane of the second baffle can be angled at about 20 degrees relative to the axis, a second vane of the second baffle can be angled at about 33 degrees relative to the axis, and a third vane of the second baffle can be angled at about 42 degrees relative to the axis.

In some examples, the baffle system can further include a pair of side plates extending between ends of the first baffle and the second baffle to partially enclose sides of the baffles.

According to another aspect of the present disclosure, a method of directing airflow in a data center can include drawing air through a coolant distribution unit (CDU) from a first end to a second end via one or more fans forming a first fan row. The method can also include redirecting the air exiting one or more fans of the first fan row at the second end of the CDU using a baffle system including a first baffle formed of a series of vanes, each vane forming an angle relative to an axis parallel to an airflow direction through the CDU, and the angle of each successive vane increasing relative to the previous vane.

In some examples, a first vane of the first baffle can be angled at about 10 degrees relative to the axis, a second vane can be angled at about 20 degrees relative to the axis, and a third vane can be angled at about 27 degrees relative to the axis.

In some examples, the coolant distribution unit can further include one or more fans forming a second fan row, and the baffle system can further include a second baffle to redirect air exiting the one or more fans of the second fan row.

In some examples, a first vane of the second baffle can be angled at about 20 degrees relative to the axis, a second vane can be angled at about 33 degrees relative to the axis, and a third vane can be angled at about 42 degrees relative to the axis.

In some examples, the first vane of the first baffle can have a length of about 5 inches, the second vane of the first baffle can have a length of about 2 inches, and the third vane of the first baffle can have a length of about 2.5 inches.

In some examples, the first vane of the second baffle can have a length of about 2 inches, the second vane of the second baffle can have a length of about 2 inches, and the third vane of the second baffle can have a length of about 1.25 inches.

In some examples, the baffle system can further include a pair of side plates extending between ends of the first baffle and the second baffle to partially enclose sides of the baffles.

According to yet another aspect of the present disclosure, a data center cooling system can include a rack of electrical equipment and a coolant distribution unit (CDU) installed within the rack. The CDU can have a first end facing a cold aisle and a second end facing a hot aisle. The system can include a first fan row including one or more fans to draw air through the CDU from the first end to the second end, and a second fan row including one or more fans to draw air through the CDU from the first end to the second end. A baffle system can be secured to the second end of the CDU, the baffle system including a first baffle to guide air exhausted by the fans of the first fan row, and a second baffle to guide air exhausted by the fans of the second fan row. The first and second baffles can have a plurality of vanes angled relative to an axis parallel to an airflow direction through the CDU, with the angle of each successive vane increasing relative to the previous vane.

In some examples, an overall angular offset of the first baffle with respect to the axis can be different than an overall angular offset of the second baffle with respect to the axis.

In some examples, for the first baffle, a first vane can be angled at about 10 degrees relative to the axis, a second vane can be angled at about 20 degrees relative to the axis, and a third vane can be angled at about 27 degrees relative to the axis.

In some examples, for the second baffle, a first vane can be angled at about 20 degrees relative to the axis, a second vane can be angled at about 33 degrees relative to the axis, and a third vane can be angled at about 42 degrees relative to the axis.

In some examples, the baffle system can further include a pair of side plates extending between ends of the first baffle and the second baffle to partially enclose sides of the baffles.

Features which are described in the context of separate aspects and/or embodiments of the invention may be used together and/or be interchangeable wherever possible. Similarly, where features are, for brevity, described in the context of a single embodiment, those features may also be provided separately or in any suitable sub- combination. Features described in connection with the coolant distribution unit may have corresponding features definable and/or combinable with respect to a method or vice versa, and these embodiments are specifically envisaged.

### BRIEF DESCRIPTION OF THE DRAWINGS

The accompanying drawings, which are incorporated in and form a part of this specification, illustrate embodiments of the invention and, together with the description, serve to explain the principles of embodiments of the invention:
FIG. 1 is a diagrammatic view of a data center including a coolant distribution unit (CDU) according to aspects of the present disclosure.
FIG. 2 is a diagrammatic view of the data center including the CDUs of FIG. 1.
FIG. 3 is an axonometric view of an example of the CDU of FIG. 1.
FIG. 4 is a cross-sectional view of the CDU of FIG. 3, taken along line IV-IV of FIG. 3.
FIG. 5 is a side view of a first baffle of the CDU of FIG. 3.
FIG. 6 is a side view of a second baffle of the CDU of FIG. 3.
FIG. 7 is a flow diagram showing a distribution of air flow from the CDU of FIG. 3.
FIG. 8 is another flow diagram showing a distribution of air flow from the CDU of FIG. 3.

### DETAILED DESCRIPTION

The following discussion is presented to enable a person skilled in the art to make and use embodiments of the invention. Given the benefit of this disclosure, various modifications to the illustrated embodiments will be readily apparent to those skilled in the art, and the principles herein can be applied to other embodiments and applications without departing from embodiments of the invention. Thus, embodiments of the invention are not intended to be limited to embodiments shown, but are to be accorded the widest scope consistent with the principles and features disclosed herein.

The following detailed description is to be read with reference to the figures, in which like elements in different figures have like reference numerals. The figures, which are not necessarily to scale, depict selected embodiments and are not intended to limit the scope of embodiments of the invention. Skilled artisans will recognize the examples provided herein have many useful alternatives and fall within the scope of embodiments of the invention.

Before any embodiments of the invention are explained in detail, it is to be understood that the invention is not limited in its application to the details of construction and the arrangement of components set forth in the following description or illustrated in the following drawings. The invention is capable of other embodiments and of being practiced or of being carried out in various ways. Also, it is to be understood that the phraseology and terminology used herein is for the purpose of description and should not be regarded as limiting. The use of "including," "comprising," or "having" and variations thereof herein is meant to encompass the items listed thereafter and equivalents thereof as well as additional items. Unless specified or limited otherwise, the terms "mounted," "connected," "supported," and "coupled" and variations thereof are used broadly and encompass both direct and indirect mountings, connections, supports, and couplings. Further, "connected" and "coupled" are not restricted to physical or mechanical connections or couplings.

In some cases, CDUs can be provided to cool electrical equipment within a data center. CDUs can be sized and configured to be installed within a rack of electrical equipment (i.e., an "in-rack CDU"). An in-rack liquid-to-air (LTA) CDU includes a liquid inlet, a liquid outlet, and a plurality of fans. Liquid coolant (e.g., water, or other cooling fluid) can flow through the inlet to a LTA heat exchanger (HX) within the LTA CDU, and heated coolant can flow from the LTA HX to the liquid outlet. The fans can produce an air flow across the LTA HX to transfer a heat from the liquid coolant to the air. The LTA can define a first (e.g., a front) side that faces a cold aisle when the LTA CDU is installed in a rack of electrical equipment, and a second side (e.g., a rear side) that faces a hot aisle when the LTA CDU is installed in the rack. In some examples, the fans are on the back of the LTA, and can operate to pull air from the cold aisle through the CDU (e.g., across the LTA HX) and blow it out to the hot aisle.

In some configurations, consecutive rows (e.g., two rows) of electrical equipment (e.g., racks including servers, storage disks and drives, networking switches, power supply unit, battery banks, cooling units, etc.), share a hot aisle. For example, a hot aisle can be defined between a first row and a second row, and cooling fans (e.g., fans of CDUs) of both of the first row and the second row can blow air into the hot aisle. An example arrangement of electrical equipment within a data center may include a LTA CDU within a row of electrical equipment on a first side of a hot aisle, and additional electrical equipment (e.g., information technology (IT) equipment) within a row on an opposite side of the hot aisle from the LTA CDU.

Where rows of electrical equipment are arranged opposite each other across a hot aisle, it can be advantageous to direct a flow of air from CDUs. For example, if fans of CDUs on opposite sides of a hot aisle blow directly into the aisle (e.g., in a direction transverse to a length-wise direction of the hot aisle, directly toward electrical equipment directly opposite the aisle from the CDU), a friction drag can reduce an airflow which can increase an energy required to circulate air from the hot aisle (e.g., away from the electrical equipment) Thus, it can be beneficial to redirect the air flow, to reduce an unwanted air friction drag.

Air can be directed from a CDU (e.g., an in-rack CDU) to satisfy air flow conditions and requirements for an aisle within a data center. For example, baffles can be provided at the LTA CDU to direct an air flow through the hot aisle. In some cases, an air flow require can require that an air flow rate from the LTA CDU at one or more locations along the hot air aisle can be diminished. The baffles can be angled relative to the LTA CDU and can at least partially extend into the hot aisle. In some examples, the baffles can be mounted at a rear side of the CDU adjacent to fans of the CDU. In some examples, each baffle extends along a corresponding row of fans (e.g., each of the baffles extend horizontally along a side of the fans of the respective row). For example, where a CDU includes two rows of two fans (e.g., a 4X4 arrangement) a single baffle can be provided for the two fans of a row, for a total of two baffles. In some examples, the air baffles can define a uniform cross-section.

In some examples, the air baffle may include three vanes. The vanes can be discrete linear sections of the baffle. In some cases, each vane can be angled relative to an axis that extends from the rear of the CDU into a hot aisle (e.g., in a direction transverse to a lengthwise direction of the aisle, and parallel to a flow of air through the CDU from a front to a rear). It can be advantageous to change an air flow direction gradually, as this can minimize an air friction at the respective vanes, and can further reduce a pressure drop at the vanes. Reducing or minimizing a pressure drop at the vanes can advantageously decrease a power consumption required to produce an air flow. In some examples, the first vane can have a length of about 5 inches and can be angled relative to an axis parallel to an air flow direction through the CDU at about a 10 degree angle. A second vane can define a length of about 2 inches, and can be angled relative to the axis by about 20 degrees, and the third vane can define a length of about 2.5 inches and can be angled relative to the axis at about a 27 degree angle. The baffle can extend from a rear of the CDU by about 8.5 inches, and a projected width of the baffle in a lengthwise direction of the hot aisle (e.g., transverse the axis) is about 2.6 inches.

In some examples, the baffles can be substantially identical (e.g., dimensions of the baffles are substantially identical) to reduce system complexity and costs. In some cases, a first baffle can be differently dimensioned from a second baffle. For example, a second baffle can define a sharper angle relative to an airflow axis through the CDU (e.g., from a front of the CDU to a rear of the CDU), to direct airflow at a different angle than the first baffle.

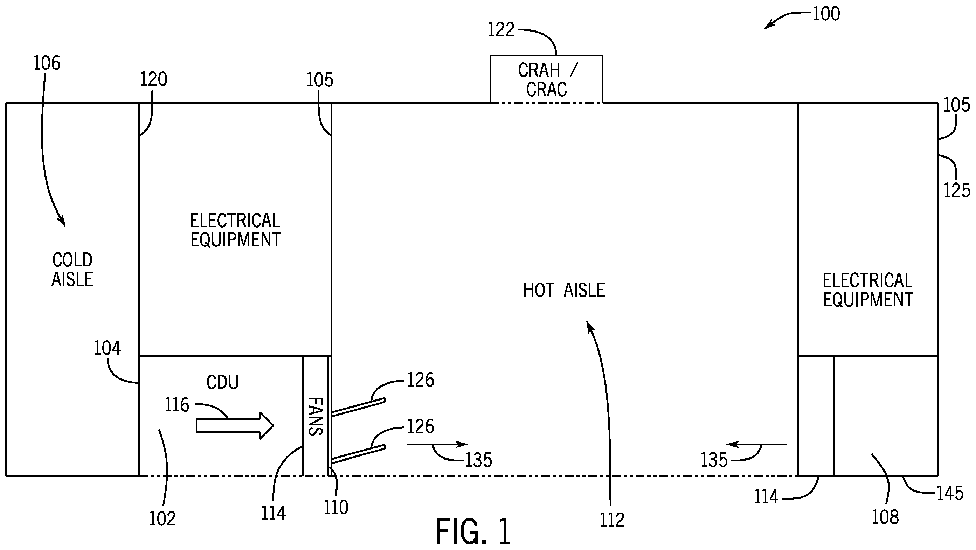

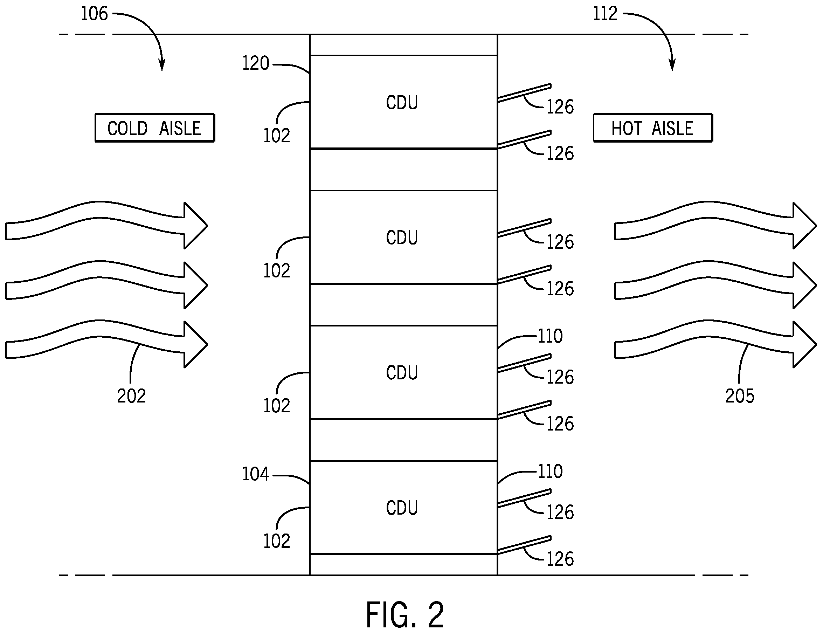

As shown in FIGS. 1 and 2 a data center 100 may include one or more racks 105 of electrical equipment 108 (e.g., servers, storage disks and drives, networking switches, power supply units, battery banks, coolant distribution units, etc.). In some examples, the racks 105 may form aisles in the data center 100. In some examples, the aisles may be designated as "hot aisles" or "cold aisles" based on the relative temperature of the air in the aisle. For example, a cold aisle 106 may be an aisle that receives cooled air from a computer room air conditioner (CRAC) or a computer room air handler (CRAH) 122 within the data center 100. Correspondingly, a hot aisle 112 may be an aisle that receives heated air from the electrical equipment (e.g., on an opposite side of the rack 105 from the cold aisle 106). Put differently, the relatively cooler air from the cold aisle 106 may pass through the rack 105 and correspondingly cool the electrical equipment within the rack. However, heat from the electrical equipment may correspondingly warm the air as the air passes through the rack 105. This warmed air may pass into the hot aisle 112, and move towards the CRAC/CRAH 122, which may cool the air from the hot aisle 112 and reinject the cooled air into the cold aisle 106.

In some examples, one or more coolant distribution units (CDU) 102 may be housed within a rack 120. For example, the CDU may be in the form of a liquid-to-air in-rack CDU. However, in other examples, the CDU may be another form of in-rack CDU (e.g., an air-to-liquid CDU, etc.). In some examples, the CDU 102 may be oriented so that a first end 104 of the CDU (e.g., an inlet end) faces the cold aisle 106, while a second end 110 of the CDU (e.g., an outlet end) faces the hot aisle 112. Further, in some examples, the CDU 102 may include one or more fans 114, which may be configured to pull air through the CDU (e.g., from the first end to the second end as shown by arrow 116). Thus, in some examples, the fans 114 may be configured to pull cooled air from the cold aisle 106 (e.g., as shown by arrows 202) through the first end of the CDU for cooling of electrical equipment. Following this, the fans 114 may exhaust the heated air from the second end of the CDU into the hot aisle 112 (e.g., as shown by arrows 205).

In some examples, it may be advantageous to direct the exhaust air from the fans 114 to reduce the amount of energy required to operate the data center 100. For example, if fans 114 of CDUs (e.g., CDU 102 and a CDU 145) on opposite sides of the hot aisle 112 each exhaust air directly into the hot aisle 112 (e.g., in the direction shown by arrows 135, towards each other and perpendicular to the hot aisle), a friction drag can be generated, which can reduce overall airflow and can increase the amount of energy required to circulate air from the hot aisle (e.g., away from the electrical equipment). This friction drag phenomenon occurs when opposing airflows collide, creating turbulence, eddy currents, and pressure differentials that the fans must work against. The resulting turbulence can create localized hot spots, reduce cooling efficiency, and potentially lead to equipment overheating in certain areas of the data center. Thus, it can be beneficial to redirect the air flow from the fans 114 of the CDU 102 (e.g., to direct the air flow into the hot aisle at a non-perpendicular angle), to reduce an unwanted air friction drag.

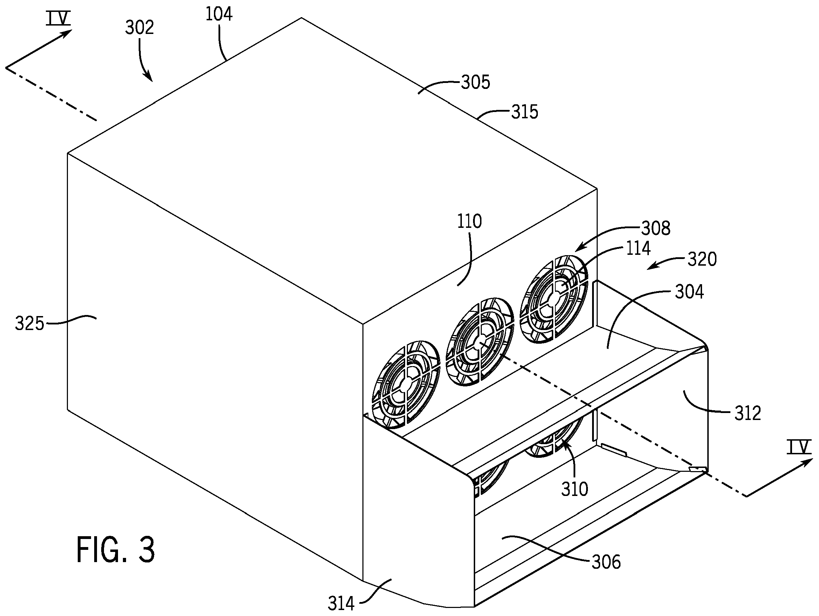

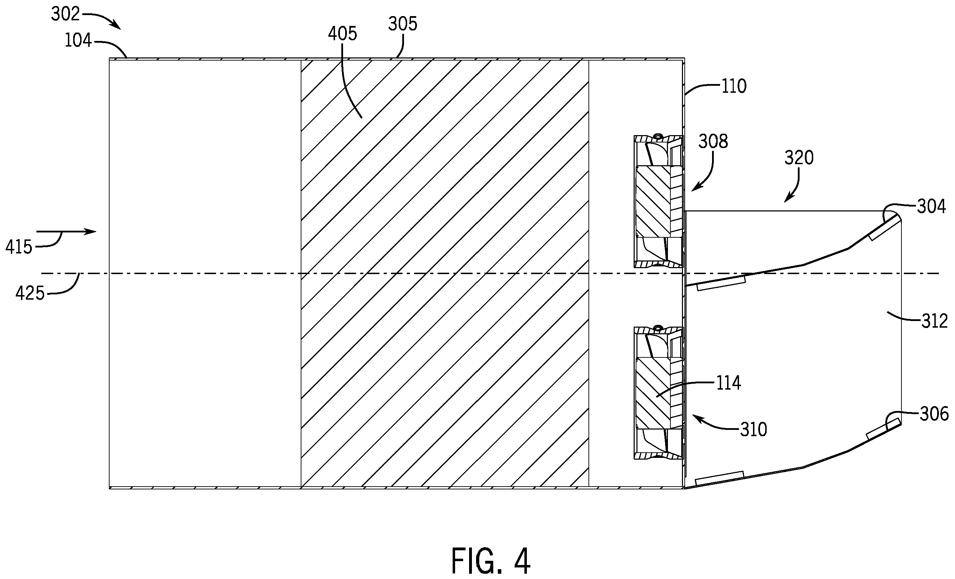

Turning to FIGS. 3 and 4, an example of a CDU 302 including a baffle system 320 is shown. In some examples, the baffle system 320 may be configured to redirect air flow (e.g., exhaust air) from the fans 114. In some examples, the baffle system 320 may include a first baffle 304 and a second baffle 306, which may correspond to the number of rows of fans 114 of the CDU 302. This one-to-one correspondence between baffles and fan rows allows for precise control of airflow patterns from each fan group. For example, the CDU 302 may include a first row 308 of fans 114 and a second row 310 of fans 114. Thus, the CDU 302 may include a first baffle (e.g., baffle 304) and a second baffle (e.g., baffle 306).

In some configurations, the baffle system 320 may incorporate adjustable elements that can be reconfigured based on changing airflow requirements or equipment arrangements. The baffles may be designed with modular components that allow for field customization or replacement without requiring complete system disassembly. As should be appreciated, varying numbers of fans, rows of fans, and baffles are envisioned. In some examples, the baffles 304, 306 can be substantially identical (e.g., dimensions of the baffles are substantially identical) to reduce system complexity and costs. In some cases, the first baffle 304 can be differently dimensioned from the second baffle 306. For example, the second baffle 306 can define a different angle relative to an airflow direction through the CDU.

In some examples, the first baffle 304 and the second baffle 306 may be secured to the second end 110 of a CDU housing 305 and extend between a first side 315 and a second side 325 of the CDU housing 305. In some examples, to further direct air flow from the fans 114, the baffle system 320 may include one or more side plates, which may enclose or partially enclose the sides of the baffles in order to mitigate air escaping from the sides of the baffles. For example, a first side plate 312 may be secured to the second end 110 of the housing 305 on the first side 315 of the housing, while a second side plate 314 may be secured to the second end 110 of the housing 305 on the second side 325 of the housing. In some examples, the first and second side plates 312, 314 may extend between the first baffle 304 and the second baffle 306.

In some examples, the first baffle 304 may be configured to direct air flow from the first row 308 of fans 114, while the second baffle 306 may be configured to direct air flow from the second row 310 of fans 114. This dedicated baffle-to-fan-row relationship enables precise airflow management for each section of the CDU, allowing for optimized cooling performance across the entire unit. The baffles may be specifically designed to match the airflow characteristics of their corresponding fan rows, taking into account factors such as fan diameter, rotational speed, and air volume delivery. In some implementations, the baffles may incorporate specialized features such as micro-vanes or air-guiding channels to further refine the airflow pattern.

In one example use case, as the fans 114 work to pull air from the cold aisle, cooled air passes into the first end 104 of the CDU (e.g., in the direction shown by arrow 415) and passes over a heat exchanger 405 within the housing 305 (e.g., a liquid-to-air heat exchanger). As the cooled air passes over the heat exchanger 405, the liquid within the heat exchanger 405 is cooled, while the air is heated. This heated air is drawn by the fans 114 through the second end 110 of the housing 305 and exhausted via the fans 114. However, as the air is exhausted by the fans 114, the air exhausted by the first row 308 of fans 114 is redirected by the first baffle 304, while the air exhausted by the second row 310 of fans 114 is redirected by the second baffle 306. In some examples, the redirection of air from the fans 114 may guide air from the fans 114 towards the CRAC/CRAH of the data center, while avoiding head on collision with air exhausted by another set of fans (e.g., in another CDU on an opposite side of the hot aisle). This coordinated airflow management can significantly reduce turbulence and improve the overall efficiency of the cooling system. In some examples, the particular shape or angle of the baffles may be designed to guide air flow from the fans in a particular direction with respect to an axis 425 extending parallel to the first and second sides 315, 325 of the housing 305. The specific angles and contours of the baffles may be determined through computational fluid dynamics (CFD) modeling to achieve optimal airflow patterns for various data center configurations and equipment densities.

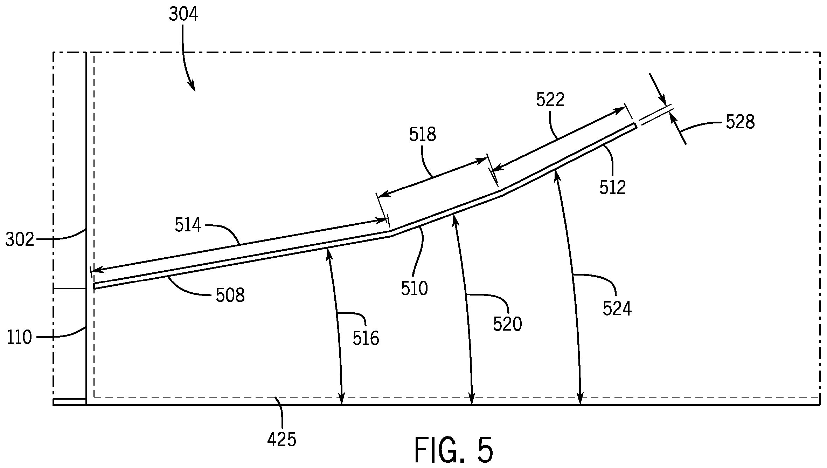

FIG. 5 illustrates an example of the first baffle 304 of the baffle system 320. In some examples, the first baffle 304 may include three vanes, which may each be form separate sections of the baffle 304, with different angles, lengths, etc. For example, each vane may be angled relative to the axis 425 (e.g., parallel to a flow of air through the CDU from the first end to the second end). This multi-vane design creates a progressive redirection of airflow that minimizes turbulence and pressure drop compared to a single, sharply angled surface. The gradual transition provided by multiple vanes helps maintain laminar flow characteristics while effectively changing the direction of the exhaust air. The specific geometry of each vane may be optimized through computational fluid dynamics (CFD) analysis to achieve the desired airflow patterns while minimizing energy losses. In some implementations, the vanes may incorporate micro-features such as serrated edges, dimpled surfaces, or trailing edge modifications to further enhance aerodynamic performance.

In other examples, the baffle 304 may include more or less than three vanes (e.g., a single vane, two vanes, four vanes, etc.). A single-vane configuration might be suitable for applications with lower airflow volumes or less stringent directional requirements, while configurations with four or more vanes might be implemented in scenarios requiring extremely precise airflow control or particularly gradual directional transitions. The number of vanes may also be determined based on spatial constraints, manufacturing considerations, or specific airflow characteristics of the fans being used. Alternative baffle designs might incorporate curved continuous surfaces rather than discrete vanes, or hybrid approaches combining both elements to achieve specific airflow management objectives. Further, in some examples, rather than having each vane form a flat, planar structure (e.g., a plane), the vanes may instead have a curvature, arcuate surface, etc.

In some examples, it may be advantageous to change an air flow direction gradually, to minimize an air friction at the respective vanes, and can further reduce a pressure drop at the vanes. Reducing or minimizing a pressure drop at the vanes can advantageously decrease a power consumption required to produce an air flow. In some examples, a first vane 508 of the baffle 304 may define a first length 514 of about 5 inches and may be angled relative to the axis 425 at a first angle 516 of about 10 degrees. A second vane 510 of the baffle 304 may define a second length 518 of about 2 inches, and may be angled relative to the axis 425 by a second angle 520 of about 20 degrees. In some examples, a third vane 512 may define a third length 522 of about 2.5 inches and may be angled relative to the axis 425 at a third angle 524 of about 27 degrees. In some examples, the baffle 304 may extend from the second end 110 of the housing 305 by about 8.5 inches, and a projected width of the baffle (e.g., transverse the axis 425) may be about 2.6 inches. These overall dimensions are designed to provide sufficient airflow control while remaining compatible with standard rack spacing and clearance requirements in data center environments. The specific projection distance may be optimized based on the particular hot aisle width and equipment arrangement to ensure proper airflow patterns without creating obstruction issues. Further, in some examples, a thickness of the baffle 304 may be about .050 inches.

In some examples, a first end of the first vane 508 may be secured to the second end 110 of the housing 305 of the CDU 302, with a second end of the first vane 508 secured to a first end of the second vane 510. Correspondingly, a second end of the second vane 510 may be secured to a first end of the third vane 512, with the second end of the third vane 512 being a free end.

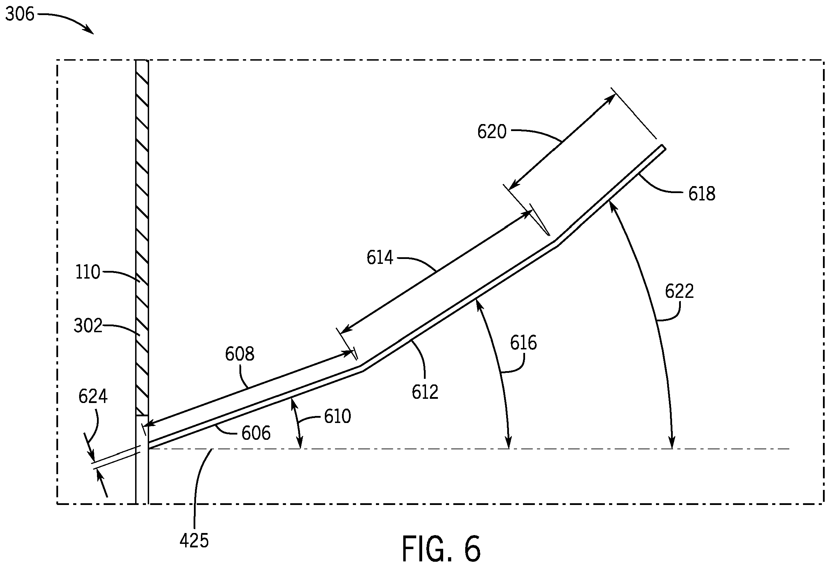

FIG. 6 illustrates an example of the second baffle 306 of the baffle system 320. In some examples, the second baffle 306 may include three vanes, which may each be form separate sections of the second baffle 306, with different angles, lengths, etc. For example, each vane may be angled relative to the axis 425 (e.g., parallel to a flow of air through the CDU from the first end to the second end). In other examples, the second baffle 306 may include more or less than three vanes (e.g., a single vane, two vanes, four vanes, etc.).

In other examples, the baffle 306 may include more or less than three vanes (e.g., a single vane, two vanes, four vanes, etc.). A single-vane configuration might be suitable for applications with lower airflow volumes or less stringent directional requirements, while configurations with four or more vanes might be implemented in scenarios requiring extremely precise airflow control or particularly gradual directional transitions. The number of vanes may also be determined based on spatial constraints, manufacturing considerations, or specific airflow characteristics of the fans being used. Alternative baffle designs might incorporate curved continuous surfaces rather than discrete vanes, or hybrid approaches combining both elements to achieve specific airflow management objectives. Further, in some examples, rather than having each vane form a flat, planar structure (e.g., a plane), the vanes may instead have a curvature, arcuate surface, etc.

In some examples, the second baffle 306 and the first baffle 304 may be substantially identical (e.g., dimensions, angles, etc. of the baffles are substantially identical) to reduce system complexity and costs. However, in some examples, the first baffle 304 can be differently dimensioned from the second baffle 306. For example, the second baffle 306 may define a sharper angle relative to the axis 425 than the first baffle 304.

In some examples, a first vane 606 of the second baffle 306 may define a first length 608 of about 2 inches and may be angled relative to the axis 425 at a first angle 610 of about 20 degrees. A second vane 612 of the second baffle 306 may define a second length 614 of about 2 inches, and may be angled relative to the axis 425 by a second angle 616 of about 33 degrees. In some examples, a third vane 618 may define a third length 620 of about 1.25 inches and may be angled relative to the axis 425 at a third angle 622 of about 42 degrees. Further, in some examples, a thickness of the baffle 304 may be about .050 inches.

In some examples, a first end of the first vane 606 may be secured to the second end 110 of the housing 305 of the CDU 302, with a second end of the first vane 606 secured to a first end of the second vane 612. Correspondingly, a second end of the second vane 612 may be secured to a first end of the third vane 618, with the second end of the third vane 618 being a free end.

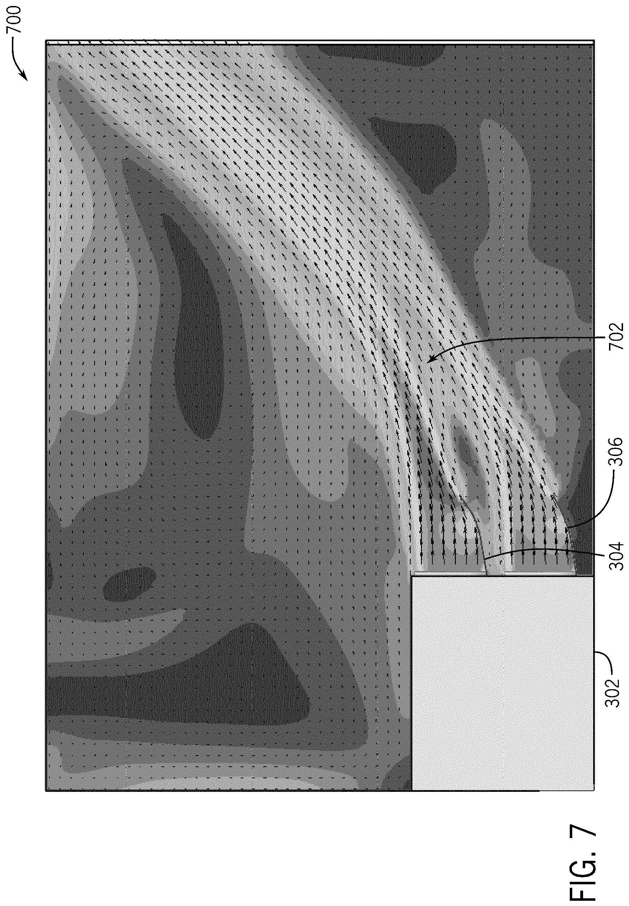

FIG. 7 shows an example flow diagram 700 for exhaust air from the fans 114 using the baffle system 320 including the first baffle 304 and the second baffle 306. As shown, using the baffle system 320, a laminar flow path 702 can be generated, with flow being redirected via the baffles 304, 306 in a generally curved profile, which can be optimized by a user to facilitate guidance of exhaust air from the fans. The computational fluid dynamics (CFD) simulation visualizes how the baffle system effectively transforms the perpendicular fan exhaust into a smoothly redirected airflow pattern that guides air flow towards the CRAC/CRAH system. The simulation demonstrates how the progressive vane angles work together to create a continuous flow path with minimal turbulence or recirculation zones. The visualization shows velocity vectors throughout the airflow field, highlighting areas of consistent flow and identifying any potential problem areas where flow separation or turbulence might occur. Thus, a user may be able to select a baffle profile sufficient to guide exhaust air in the desired direction (e.g., to avoid generating turbulent flow, etc.) and reduce overall data center operating costs.

In some examples, the baffle profile selection may be based on various factors, including hot aisle width, equipment density, fan specifications, and overall cooling requirements. In some implementations, modular or adjustable baffle systems might allow for field optimization based on specific installation conditions or changing operational requirements. The CFD modeling approach enables predictive analysis of different baffle configurations before physical implementation, reducing trial-and-error adjustments and associated costs. Beyond energy savings, the optimized airflow patterns can provide additional benefits such as more uniform temperature distribution, reduced acoustic noise, and potentially extended equipment lifespan due to improved thermal management. Alternative baffle designs might incorporate active elements such as motorized vanes that automatically adjust based on temperature sensors or airflow measurements to dynamically optimize cooling performance under varying load conditions.

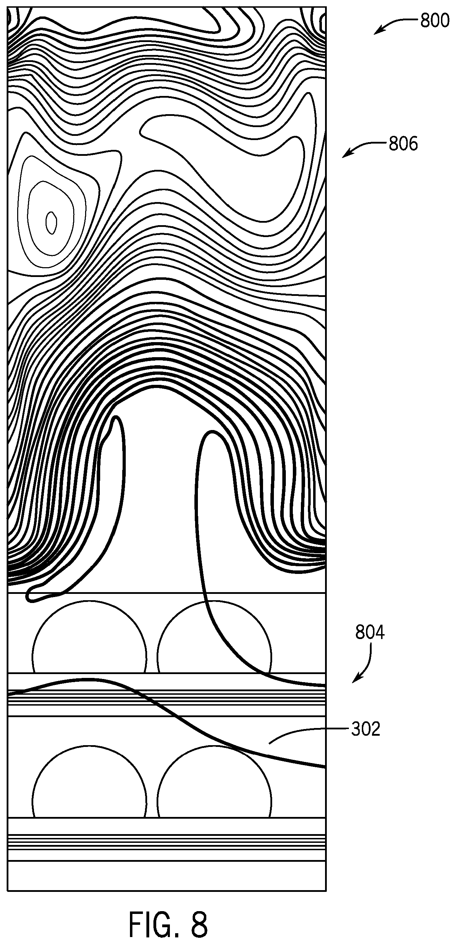

FIG. 8 shows an example flow diagram 800 taken on a plan perpendicular to the CDU 302. As shown, there is little velocity in a first region 804, with an increasing velocity in a second region 806. In some examples, velocity is an input variable in a dynamic pressure calculation (dynamic pressure = ½ * rho * velocity squared, where rho is the density). Thus, as shown in FIG. 8, there is a low dynamic pressure in the first region 804 (e.g., at a bottom of the hot aisle) due to the baffle system, while there is a higher dynamic pressure in the second region 806. Further, as a result of this lower dynamic pressure in the first region 804, a second CDU arranged opposite the first CDU (e.g., across the hot aisle) will not have to fight against a high dynamic pressure to exhaust air from the fans into the hot aisle, reducing overall power requirements.

In some implementations, devices or systems disclosed herein can be utilized, manufactured, or installed using methods embodying aspects of the invention. Correspondingly, any description herein of particular features, capabilities, or intended purposes of a device or system is generally intended to include disclosure of a method of using such devices for the intended purposes, a method of otherwise implementing such capabilities, a method of manufacturing relevant components of such a device or system (or the device or system as a whole), and a method of installing disclosed (or otherwise known) components to support such purposes or capabilities. Similarly, unless otherwise indicated or limited, discussion herein of any method of manufacturing or using for a particular device or system, including installing the device or system, is intended to inherently include disclosure, as embodiments of the invention, of the utilized features and implemented capabilities of such device or system.

### FURTHER EXAMPLES

Example 1. A coolant distribution unit (CDU), comprising: a housing having a first end and a second end; a first fan row arranged on the second end of the housing, the first fan row including a first fan to move air through the housing from the first end to the second end; and a baffle system secured to the second end of the housing, the baffle system including: a first baffle to guide air flow from the first fan row, the first baffle having a plurality of sequentially arranged vanes, each vane defining a plane forming an angle relative to an axis parallel to an airflow direction through the CDU, and each vane in the sequence being oriented at a greater angle relative to the axis than the preceding vane in the sequence.

Example 2. The coolant distribution unit of Example 1, wherein the first baffle includes three vanes.

Example 3. The coolant distribution unit of Example 1 or 2, wherein a first vane is angled at about 10 degrees relative to the axis, a second vane is angled at about 20 degrees relative to the axis, and a third vane is angled at about 27 degrees relative to the axis.

Example 4. The coolant distribution unit of any one of Examples 1 to 3, wherein the first vane has a length of about 5 inches, the second vane has a length of about 2 inches, and the third vane has a length of about 2.5 inches.

Example 5. The coolant distribution unit of any one of Examples 1 to 4, further comprising: a second fan row arranged on the second end of the housing, the second fan row including a second fan to move air through the housing from the first end to the second end.

Example 6. The coolant distribution unit of Example 5, wherein the baffle system further comprises: a second baffle to guide air flow from the second fan row, the second baffle having a plurality of sequentially arranged vanes, each vane defining a plane forming an angle relative to an axis parallel to an airflow direction through the CDU, and each vane in the sequence being oriented at a greater angle relative to the axis than the preceding vane in the sequence.

Example 7. The coolant distribution unit of Example 6, wherein the second baffle includes three vanes, and wherein a first vane of the second baffle is angled at about 20 degrees relative to the axis, a second vane of the second baffle is angled at about 33 degrees relative to the axis, and a third vane of the second baffle is angled at about 42 degrees relative to the axis.

Example 8. The coolant distribution unit of Example 6 or 7, wherein the baffle system further comprises: a pair of side plates extending between ends of the first baffle and the second baffle to partially enclose sides of the baffles.

Example 9. A method of directing airflow in a data center, the method comprising: drawing air through a coolant distribution unit (CDU) from a first end to a second end via one or more fans forming a first fan row; and redirecting the air exiting one or more fans of the first fan row at the second end of the CDU using a baffle system including a first baffle formed of a series of vanes, each vane forming an angle relative to an axis parallel to an airflow direction through the CDU, and the angle of each successive vane increasing relative to the previous vane.

Example 10. The method of Example 9, wherein a first vane of the first baffle is angled at about 10 degrees relative to the axis, a second vane is angled at about 20 degrees relative to the axis, and a third vane is angled at about 27 degrees relative to the axis.

Example 11. The method of Example 9 or 10, wherein the coolant distribution unit further includes: one or more fans forming a second fan row; and wherein the baffle system further includes: a second baffle to redirect air exiting the one or more fans of the second fan row.

Example 12. The method of Example 11, wherein a first vane of the second baffle is angled at about 20 degrees relative to the axis, a second vane is angled at about 33 degrees relative to the axis, and a third vane is angled at about 42 degrees relative to the axis.

Example 13. The method of any one of Examples 10 to 12, wherein the first vane of the first baffle has a length of about 5 inches, the second vane of the first baffle has a length of about 2 inches, and the third vane of the first baffle has a length of about 2.5 inches.

Example 14. The method of Example 12 or 13, wherein the first vane of the second baffle has a length of about 2 inches, the second vane of the second baffle has a length of about 2 inches, and the third vane of the second baffle has a length of about 1.25 inches.

Example 15. The method of any one of Examples 11 to 14, wherein the baffle system further includes: a pair of side plates extending between ends of the first baffle and the second baffle to partially enclose sides of the baffles.

Example 16. A data center cooling system, comprising: a rack of electrical equipment; a coolant distribution unit (CDU) installed within the rack, the CDU having a first end facing a cold aisle and a second end facing a hot aisle; a first fan row including one or more fans to draw air through the CDU from the first end to the second end; a second fan row including one or more fans to draw air through the CDU from the first end to the second end; and a baffle system secured to the second end of the CDU, the baffle system including: a first baffle to guide air exhausted by the fans of the first fan row; and a second baffle to guide air exhausted by the fans of the second fan row, the first and second baffles having a plurality of vanes angled relative to an axis parallel to an airflow direction through the CDU, with the angle of each successive vane increasing relative to the previous vane.

Example 17. The data center cooling system of Example 16, wherein an overall angular offset of the first baffle with respect to the axis is different than an overall angular offset of the second baffle with respect to the axis.

Example 18. The data center cooling system of Example 16 or 17, wherein for the first baffle, a first vane is angled at about 10 degrees relative to the axis, a second vane is angled at about 20 degrees relative to the axis, and a third vane is angled at about 27 degrees relative to the axis.

Example 19. The data center cooling system of any one of Examples 16 to 18, wherein for the second baffle, a first vane is angled at about 20 degrees relative to the axis, a second vane is angled at about 33 degrees relative to the axis, and a third vane is angled at about 42 degrees relative to the axis.

Example 20. The data center cooling system of any one of Examples 16 to 19, wherein the baffle system further includes: a pair of side plates extending between ends of the first baffle and the second baffle to partially enclose sides of the baffles.

Also as used herein, unless otherwise limited or defined, "or" indicates a non-exclusive list of components or operations that can be present in any variety of combinations, rather than an exclusive list of components that can be present only as alternatives to each other. For example, a list of "A, B, or C" indicates options of: A; B; C; A and B; A and C; B and C; and A, B, and C. Correspondingly, the term "or" as used herein is intended to indicate exclusive alternatives only when preceded by terms of exclusivity, such as "either," "one of," "only one of," or "exactly one of." For example, a list of "one of A, B, or C" indicates options of: A, but not B and C; B, but not A and C; and C, but not A and B. A list preceded by "one or more" (and variations thereon) and including "or" to separate listed elements indicates options of one or more of any or all of the listed elements. For example, the phrases "one or more of A, B, or C" and "at least one of A, B, or C" indicate options of: one or more A; one or more B; one or more C; one or more A and one or more B; one or more B and one or more C; one or more A and one or more C; and one or more of A, one or more of B, and one or more of C. Similarly, a list preceded by "a plurality of" (and variations thereon) and including "or" to separate listed elements indicates options of multiple instances of any or all of the listed elements. For example, the phrases "a plurality of A, B, or C" and "two or more of A, B, or C" indicate options of: A and B; B and C; A and C; and A, B, and C.

As used herein, unless otherwise defined or limited, directional terms are used for convenience of reference for discussion of particular figures or examples. For example, references to downward (or other) directions or top (or other) positions may be used to discuss aspects of a particular example or figure, but do not necessarily require similar orientation or geometry in all installations or configurations.

Also as used herein, unless otherwise limited or defined, "substantially parallel" indicates a direction that is within ± 12 degrees of a reference direction (e.g., within ± 6 degrees), inclusive.

Also as used herein, unless otherwise limited or defined, "substantially perpendicular" indicates a direction that is within ± 12 degrees of perpendicular a reference direction (e.g., within ± 6 degrees), inclusive.

Also as used herein, unless otherwise limited or defined, "integral" and derivatives thereof (e.g., "integrally") describe elements that are manufactured as a single piece without fasteners, adhesive, or the like to secure separate components together. For example, an element stamped, cast, or otherwise molded as a single-piece component from a single piece of sheet metal or using a single mold, without rivets, screws, or adhesive to hold separately formed pieces together is an integral (and integrally formed) element. In contrast, an element formed from multiple pieces that are separately formed initially then later connected together, is not an integral (or integrally formed) element.

Additionally, unless otherwise specified or limited, the terms "about" and "approximately," as used herein with respect to a reference value, refer to variations from the reference value of ± 15% or less, inclusive of the endpoints of the range. Similarly, the term "substantially equal" (and the like) as used herein with respect to a reference value refers to variations from the reference value of less than ± 10%, inclusive. Where specified, "substantially" can indicate in particular a variation in one numerical direction relative to a reference value. For example, "substantially less" than a reference value (and the like) indicates a value that is reduced from the reference value by 10% or more, and "substantially more" than a reference value (and the like) indicates a value that is increased from the reference value by 10% or more.

Also as used herein, unless otherwise limited or specified, "substantially identical" refers to two or more components or systems that are manufactured or used according to the same process and specification, with variation between the components or systems that are within the limitations of acceptable tolerances for the relevant process and specification. For example, two components can be considered to be substantially identical if the components are manufactured according to the same standardized manufacturing steps, with the same materials, and within the same acceptable dimensional tolerances (e.g., as specified for a particular process or product).

Unless otherwise specifically indicated, ordinal numbers are used herein for convenience of reference, based generally on the order in which particular components are presented in the relevant part of the disclosure. In this regard, for example, designations such as "first," "second," etc., generally indicate only the order in which a thus-labeled component is introduced for discussion and generally do not indicate or require a particular spatial, functional, temporal, or structural primacy or order.

Features which are described in the context of separate embodiments may also be provided in combination in a single embodiment. Conversely, various features which are, for brevity, described in the context of a single embodiment, may also be provided separately or in any suitable sub-combination. The applicant hereby gives notice that new claims may be formulated to such features and/or combinations of such features during the prosecution of the present application or of any further application derived therefrom. Features of the coolant distribution unit described may be incorporated into/used in corresponding methods and vice versa.

The previous description of the disclosed embodiments is provided to enable any person skilled in the art to make or use the invention. Given the benefit of this disclosure, various modifications to these embodiments will be readily apparent to those skilled in the art, and the principles defined herein may be applied to other embodiments without departing from the spirit or scope of the invention. Thus, the invention is not intended to be limited to the embodiments shown herein but is to be accorded the widest scope consistent with the principles and novel features disclosed herein.

## Claims

1. A coolant distribution unit (CDU), comprising:
a housing having a first end and a second end;
a first fan row arranged on the second end of the housing, the first fan row including a first fan to move air through the housing from the first end to the second end; and
a baffle system secured to the second end of the housing, the baffle system including:
a first baffle to guide air flow from the first fan row, the first baffle having a plurality of sequentially arranged vanes, each vane defining a plane forming an angle relative to an axis parallel to an airflow direction through the CDU, and each vane in the sequence being oriented at a greater angle relative to the axis than the preceding vane in the sequence.

2. The coolant distribution unit of claim 1, wherein the first baffle includes at least two vanes.

3. The coolant distribution unit of claim 2, wherein a first vane is angled at about 10 degrees relative to the axis, a second vane is angled at about 20 degrees relative to the axis, and a third vane is angled at about 27 degrees relative to the axis.

4. The coolant distribution unit of claim 3, wherein the first vane has a length of about 5 inches, the second vane has a length of about 2 inches, and the third vane has a length of about 2.5 inches.

5. The coolant distribution unit of claim 1 or of any of claims 2 to 4, further comprising:
a second fan row arranged on the second end of the housing, the second fan row including a second fan to move air through the housing from the first end to the second end.

6. The coolant distribution unit of claim 5, wherein the baffle system further comprises:
a second baffle to guide air flow from the second fan row, the second baffle having a plurality of sequentially arranged vanes, each vane defining a plane forming an angle relative to an axis parallel to an airflow direction through the CDU, and each vane in the sequence being oriented at a greater angle relative to the axis than the preceding vane in the sequence.

7. The coolant distribution unit of claim 6, wherein the second baffle includes three vanes, and wherein a first vane of the second baffle is angled at about 20 degrees relative to the axis, a second vane of the second baffle is angled at about 33 degrees relative to the axis, and a third vane of the second baffle is angled at about 42 degrees relative to the axis.

8. The coolant distribution unit of claim 6 or claim 7, wherein the baffle system further comprises:
a pair of side plates extending between ends of the first baffle and the second baffle to partially enclose sides of the baffles.

9. A method of directing airflow in a data center, the method comprising:
drawing air through a coolant distribution unit (CDU) from a first end to a second end via one or more fans forming a first fan row; and
redirecting the air exiting one or more fans of the first fan row at the second end of the CDU using a baffle system including a first baffle formed of a series of vanes, each vane forming an angle relative to an axis parallel to an airflow direction through the CDU, and the angle of each successive vane increasing relative to the previous vane.

10. The method of claim 9, wherein a first vane of the first baffle is angled at about 10 degrees relative to the axis, a second vane is angled at about 20 degrees relative to the axis, and a third vane is angled at about 27 degrees relative to the axis.

11. The method of claim 9 or claim 10, wherein the coolant distribution unit further includes:
one or more fans forming a second fan row; and
wherein the baffle system further includes:
a second baffle to redirect air exiting the one or more fans of the second fan row.

12. The method of claim 11, wherein a first vane of the second baffle is angled at about 20 degrees relative to the axis, a second vane is angled at about 33 degrees relative to the axis, and a third vane is angled at about 42 degrees relative to the axis.

13. The method of claim 10, claim 11 or claim 12, wherein the first vane of the first baffle has a length of about 5 inches, the second vane of the first baffle has a length of about 2 inches, and the third vane of the first baffle has a length of about 2.5 inches.

14. The method of claim 12 or claim 13, wherein the first vane of the second baffle has a length of about 2 inches, the second vane of the second baffle has a length of about 2 inches, and the third vane of the second baffle has a length of about 1.25 inches.

15. The method of claim 11 or of any of claims 12 to 14, wherein the baffle system further includes:
a pair of side plates extending between ends of the first baffle and the second baffle to partially enclose sides of the baffles.
